# DEMANDE DE BREVET EUROPEEN

(11) **EP 4 614 161 A1**
(43) Date de publication de la demande: **10.09.2025**
(21) Numéro de dépôt: 25158966.9
(22) Date de dépôt: 19.02.2025
(51) Int. Cl.: G01R 1/20, G01R 19/00

(54) **MESURE DE COURANTS FORTS AU TRAVERS D'UN SHUNT**

(30) Priorité: 05.03.2024 FR 2402201
(71) Demandeur: SAGEMCOM ENERGY & TELECOM SAS, 92270 Bois-Colombes (FR)
(72) Inventeur: GRINCOURT, Christophe, 92270 BOIS-COLOMBES (FR); TEBOULLE, Henri, 92270 BOIS-COLOMBES (FR)
(74) Mandataire: Cabinet Boettcher

(57) **Abrégé**

Dispositif de mesure de courant (20), agencé pour mesurer un courant principal (I) le traversant, et comprenant :
- un premier élément (30) qui est électriquement conducteur et qui intègre un shunt (32) ;
- un deuxième élément (46) qui est électriquement conducteur ;
chaque extrémité du premier élément étant fixée par une liaison électriquement conductrice à une extrémité distincte du deuxième élément, de sorte que le courant principal se divise en un premier courant (Il) circulant dans le premier élément et en un deuxième courant (I2) circulant dans le deuxième élément, le shunt permettant ainsi de mesurer le premier courant qui est représentatif du courant principal.

## Description

L'invention concerne les dispositifs de mesure de courant.

### ARRIERE PLAN

Les shunts sont classiquement utilisés, dans les compteurs électriques, pour mesurer le courant fourni par un réseau de distribution à une installation. Les mesures de courant sont ensuite utilisées pour évaluer la puissance et l'énergie électrique consommées par l'installation.

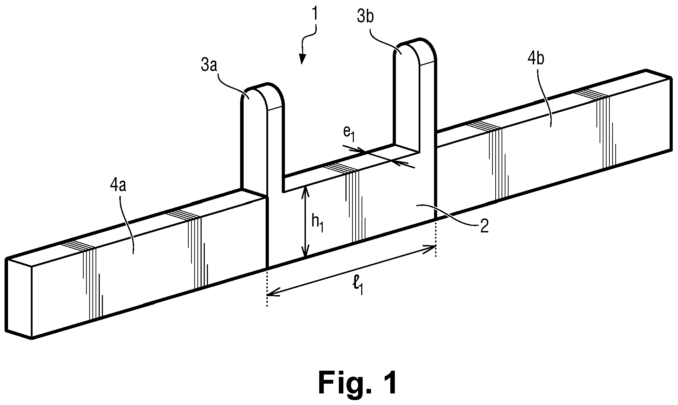

Un shunt 1 de l'art antérieur est visible sur la figure 1. Ce shunt 1 est destiné à être intégré dans un compteur électrique qui mesure des courants inférieurs à 100A.

Le shunt 1 comprend une partie principale 2 en forme de plaque rectangulaire, ainsi qu'une première borne 3a et une deuxième borne 3b situées aux extrémités de la partie principale 2. Des plaques de cuivre 4a, 4b sont fixées aux extrémités du shunt 1 de part et d'autre de celui-ci. Des fils, non représentés, sont connectés à chacune des bornes 3a, 3b et permettent de mesurer la tension aux bornes du shunt 1. Le courant circulant dans le shunt 1 est évalué à partir de ces mesures de tension.

Le shunt 1 a par exemple une longueur l₁ de 5mm, une hauteur h₁ de 8mm et une épaisseur e₁ de 1,79mm, et donc une section selon un plan perpendiculaire à sa longueur l₁ de 14,3mm². L'impédance du shunt 1 à 20°C (presqu'entièrement résistive aux fréquences considérées) est alors de 150µΩ.

Les deux plaques de cuivre 4a, 4b ont quant à elles chacune une longueur de 12,5mm, une hauteur de 8mm, une épaisseur de 1,79mm et une impédance à 20°C de 15µΩ. L'impédance totale des deux plaques de cuivre à 20°C est de 30µΩ.

On obtient donc une pièce électriquement conductrice ayant une longueur totale de 30mm et une impédance totale à 20°C de 180µΩ.

Ce shunt 1 a été conçu pour un courant maximum à mesurer de 90A. La puissance dissipée à l'intérieur du compteur électrique par le shunt 1 sous ce courant est de 1,46 W, ce qui est acceptable.

On cherche à concevoir un dispositif de mesure de courant pour un compteur mesurant des courants forts (200A ou 320A par exemple). Il semblerait de prime abord logique d'utiliser un shunt tel que celui de la figure 1.

Cependant, si un courant de 200A traverse ce shunt 1, la puissance dissipée sous ce courant fort est cette fois de 7,2W. Avec un courant de 320A, on obtient une puissance de 18,44W.

Ces puissances sont trop élevées pour un compteur électrique qui, dans sa conception standard, ne peut pas les dissiper efficacement.

Pour réduire les puissances dissipées, il est possible d'augmenter la hauteur et/ou l'épaisseur du shunt.

Par exemple, avec une hauteur du shunt de 100mm, on obtient une puissance dissipée de 1,47W. A hauteur constante, il faudrait une épaisseur de 23mm pour obtenir un résultat comparable. Ces dimensions sont cependant trop importantes pour que le shunt puisse être intégré dans un compteur électrique standard. Par ailleurs, ces solutions engendrent un surcoût important.

Il est possible aussi de réduire la longueur du shunt. Mais même avec une longueur de 1mm, qui est la longueur minimale extrême, on obtient une puissance dissipée de 6,44W, qui est à nouveau trop importante.

### OBJET

L'invention a pour objet de mesurer des courants forts en utilisant un shunt de mesure, en limitant la puissance dissipée, avec une très bonne précision de mesure et avec un coût réduit.

### RESUME

En vue de la réalisation de ce but, on propose un dispositif de mesure de courant, agencé pour mesurer un courant principal le traversant, et comprenant :
- un premier élément qui est électriquement conducteur et qui intègre un shunt ;
- un deuxième élément qui est électriquement conducteur ; chaque extrémité du premier élément étant fixée par une liaison électriquement conductrice à une extrémité distincte du deuxième élément, de sorte que le courant principal se divise en un premier courant circulant dans le premier élément et en un deuxième courant circulant dans le deuxième élément, le shunt permettant ainsi de mesurer le premier courant qui est représentatif du courant principal.

Les matériaux utilisés pour fabriquer le premier élément (et donc le shunt) et le deuxième élément peuvent être choisis de sorte que l'impédance du premier élément est beaucoup plus élevée que celle du deuxième élément. La puissance dissipée dans le shunt lorsqu'il est traversé par le premier courant et, plus généralement, la puissance dissipée par le dispositif de mesure de courant lorsqu'il est traversé par le courant principal, sont alors nettement plus faibles que si le shunt était traversé par la totalité du courant principal.

Le premier courant circulant dans le shunt est une image du courant principal, et la précision de la mesure est très bonne. Il est possible si nécessaire de compenser les différences de dérive en température des matériaux utilisés.

Le coût du dispositif de mesure de courant est peu élevé. En effet, ce dispositif utilise un shunt de conception « classique », pouvant être utilisé pour des courants faibles, et un deuxième élément qui peut être une pièce ou une partie de pièce très simple et peu coûteuse.

On propose de plus un dispositif de mesure de courant tel que précédemment décrit, comportant une pièce comprenant un côté dans lequel est formée une échancrure qui définit une portion évidée s'étendant selon une partie d'une longueur de la pièce, et une portion non évidée s'étendant selon ladite partie de la longueur de la pièce, le deuxième élément étant ladite portion non évidée, et le premier élément s'étendant dans l'échancrure de manière à laisser un espace non électriquement conducteur entre le premier élément et le deuxième élément.

On propose de plus un dispositif de mesure de courant tel que précédemment décrit, dans lequel chaque extrémité du premier élément comprend un premier renfoncement formé dans son épaisseur et chaque extrémité du deuxième élément comprend un deuxième renfoncement formé dans son épaisseur, le premier élément et le deuxième élément ayant leurs extrémités emboitées de sorte qu'un fond du premier renfoncement de chaque extrémité du premier élément est appliqué contre un fond du deuxième renfoncement d'une extrémité distincte du deuxième élément.

On propose de plus un dispositif de mesure de courant tel que précédemment décrit, dans lequel le deuxième élément est fabriqué avec au moins un matériau comprenant un alliage de cuivre.

On propose de plus un dispositif de mesure de courant tel que précédemment décrit, dans lequel le premier élément comprend le shunt et deux plaques fixées au shunt et positionnées de part et d'autre du shunt.

On propose de plus un dispositif de mesure de courant tel que précédemment décrit, dans lequel le shunt est fabriqué avec au moins un matériau comprenant de la Manganine.

On propose de plus un dispositif de mesure de courant tel que précédemment décrit, dans lequel chaque liaison électriquement conductrice est réalisée par une opération de soudure par point.

On propose de plus un dispositif de mesure de courant tel que précédemment décrit, dans lequel une résistance électrique du premier élément est comprise entre 5 fois et 100 fois une résistance électrique du deuxième élément.

On propose de plus un équipement électrique intégrant un dispositif de mesure de courant tel que précédemment décrit, l'équipement électrique comprenant une unité de traitement agencée pour :
- mesurer une tension aux bornes du shunt ;
- évaluer le courant principal à partir de ladite tension.

On propose de plus un équipement électrique tel que précédemment décrit, comprenant en outre un capteur de température, l'unité de traitement étant de plus agencée pour acquérir des mesures de température produites par le capteur de température et pour compenser, en fonction desdites mesures de température, une différence de dérive en température d'une résistance électrique du premier élément et d'une résistance électrique du deuxième élément.

On propose de plus un équipement électrique tel que précédemment décrit, l'équipement électrique étant un compteur électrique.

On propose de plus un équipement électrique tel que précédemment décrit, l'équipement électrique étant agencé pour mesurer, en utilisant le dispositif de mesure de courant, un courant principal supérieur à 100A.

On propose de plus un procédé de mesure de courant, mis en œuvre dans l'unité de traitement de l'équipement électrique tel que précédemment décrit, et comprenant les étapes de :
- mesurer une tension aux bornes du shunt ;
- acquérir des mesures de température produites par le capteur de température ;
- déterminer, en fonction de la température, une valeur d'un paramètre de compensation permettant de compenser la différence de dérive en température de la résistance électrique du premier élément et de la résistance électrique du deuxième élément ;
- corriger la tension aux bornes du shunt en utilisant ladite valeur dudit paramètre de compensation ;
- évaluer le courant principal à partir de la tension corrigée.

On propose de plus un programme d'ordinateur comprenant des instructions qui conduisent l'unité de traitement de l'équipement électrique tel que précédemment décrit à exécuter les étapes du procédé de mesure de courant tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés parmi lesquels :
[Fig. 1] la figure 1 représente une vue en perspective d'un shunt de l'art antérieur ;
[Fig. 2] la figure 2 représente un compteur dans lequel est intégré un dispositif de mesure de courant ;
[Fig. 3] la figure 3 représente une vue en perspective du dispositif de mesure de courant ;
[Fig. 4] la figure 4 représente une vue de côté du dispositif de mesure de courant.

### DESCRIPTION DETAILLEE

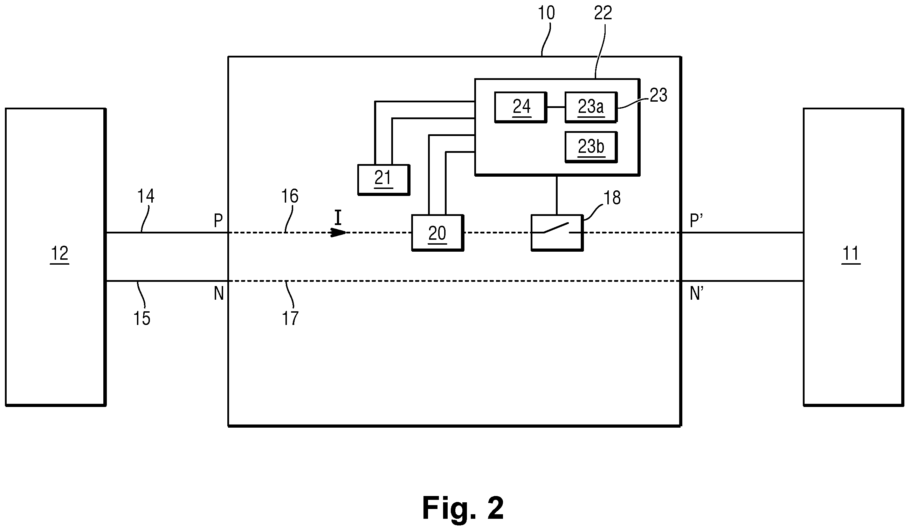

En référence à la figure 2, le compteur électrique 10 est destiné à mesurer la consommation d'énergie électrique d'une installation 11. Cette énergie électrique est fournie à l'installation 11 par un réseau de distribution 12. Le réseau de distribution 12 comprend une phase 14 et un neutre 15. Le compteur 10 est ici un compteur monophasé.

Le compteur 10 comprend une borne de phase amont P reliée à la phase 14 du réseau 12 et une borne de neutre amont N reliée au neutre 15 du réseau 12. Le compteur 10 comporte de plus une borne de phase aval P' et une borne de neutre aval N'**.**

Ici, par « amont », on entend du côté du réseau de distribution 12, et par « aval », on entend du côté de l'installation 11.

La borne de phase aval P' et la borne de neutre aval N' du compteur 10 sont reliées à l'installation 11, éventuellement via des interrupteurs intégrés dans un disjoncteur situé à l'extérieur du compteur 10 et non représenté ici.

Le compteur 10 comporte de plus un conducteur de phase 16 connecté à la phase 14 du réseau de distribution 12 via la borne de phase amont P, et reliant entre elles la borne de phase amont P et la borne de phase aval P'. Le compteur 10 comporte aussi un conducteur de neutre 17 connecté au neutre 15 du réseau de distribution 12 via la borne de neutre amont N, et reliant entre elles la borne de neutre amont N et la borne de neutre aval N'.

Le compteur 10 comporte ici un organe de coupure 18 comprenant un interrupteur monté sur le conducteur de phase 16. L'organe de coupure 18 est notamment utilisé pour couper ou rétablir à distance l'alimentation de l'installation 11 en cas, par exemple, de résiliation de l'abonnement ou de non-respect du contrat d'abonnement.

Le compteur 10 comprend de plus des composants métrologiques.

Ces composants métrologiques comprennent un capteur de tension (non représenté) qui mesure la tension appliquée par le réseau 12 aux bornes de l'installation 11 (et du compteur 10).

Les composants métrologiques comprennent aussi un dispositif de mesure de courant 20 qui est monté en amont de l'organe de coupure 18 sur le conducteur de phase 16. Le dispositif de mesure de courant 20 permet de mesurer le courant I circulant sur la phase 14 et sur le conducteur de phase 16, qui est fourni à l'installation 11 par le réseau de distribution 12.

Le compteur 10 intègre ici au moins un capteur de température (deux en l'occurrence). Ces capteurs comprennent un capteur de température 21 qui est positionné à proximité du dispositif de mesure de courant 20. Le capteur de température 21 produit des mesures de température représentatives de la température du dispositif de mesure de courant 20 et de son environnement immédiat. Le rôle de ce capteur de température 21 sera décrit plus bas.

Le compteur 10 comporte de plus une unité de traitement 22 (électronique et logicielle). L'unité de traitement 22 comprend au moins un composant de traitement 23, qui est par exemple un processeur « généraliste », un processeur spécialisé dans le traitement du signal (ou DSP, pour *Digital Signal Processor*), un microcontrôleur, ou bien un circuit logique programmable tel qu'un FPGA (pour *Field Programmable Gate Arrays*) ou un ASIC (pour *Application Specific Integrated Circuit*). L'unité de traitement 22 comprend aussi une ou des mémoires 24, reliées à ou intégrées dans le composant de traitement 23. Au moins l'une de ces mémoires 24 forme un support d'enregistrement lisible par ordinateur, sur lequel est enregistré au moins un programme d'ordinateur comprenant des instructions qui conduisent l'unité de traitement 22 à exécuter les étapes du procédé de mesure de courant qui sera décrit plus bas.

Ici, l'unité de traitement 22 comprend un microcontrôleur « métrologie » 23a qui, notamment, acquiert les mesures réalisées par les capteurs du compteur 10 et réalise certains traitements sur lesdites mesures, et un microcontrôleur « application » 23b qui, notamment, pilote l'organe de coupure 18. C'est dans le microcontrôleur métrologie 23a qu'est mis en œuvre le procédé de mesure de courant.

On s'intéresse maintenant plus précisément au dispositif de mesure de courant 20.

Le dispositif de mesure de courant 20 permet de mesurer un courant principal qui le traverse. Le courant principal est ici le courant I circulant sur la phase 14 et le conducteur de phase 16, qui est consommé par l'installation 11.

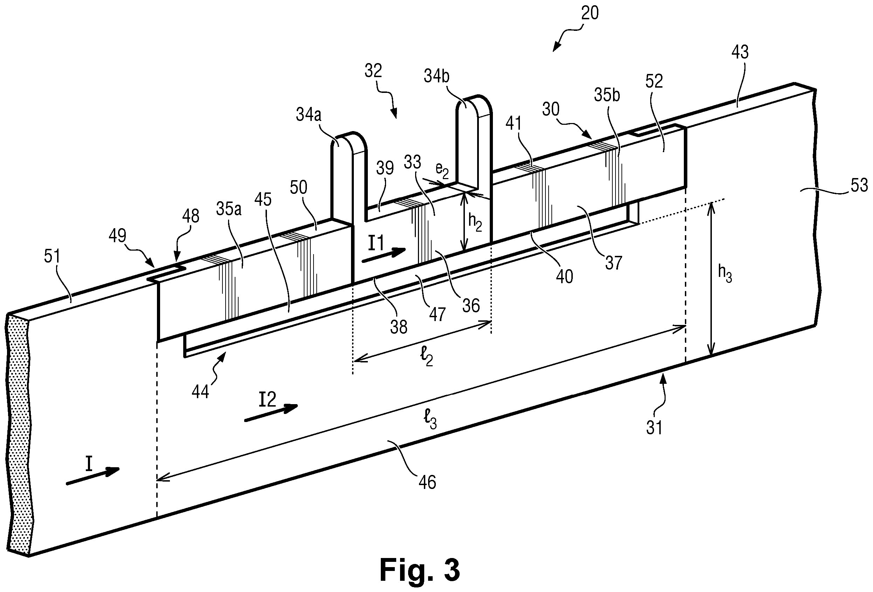

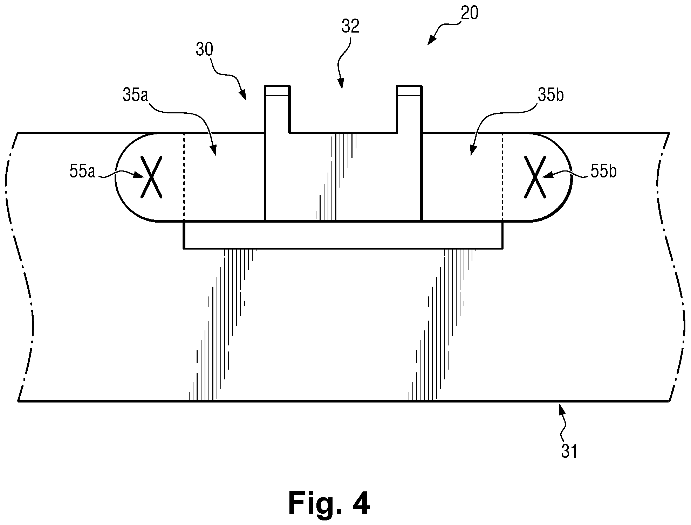

En référence aux figures 3 et 4, dans un mode de réalisation, le dispositif de mesure de courant 20 comporte deux pièces fixées l'une à l'autre : une première pièce 30 et une deuxième pièce 31.

La première pièce 30 comprend un shunt 32.

Le shunt 32 comprend une partie principale 33 en forme de plaque rectangulaire, ainsi qu'une première borne 34a et une deuxième borne 34b situées aux extrémités de la partie principale 33.

Les deux bornes 34a, 34b s'étendent chacune depuis un même côté de la partie principale 33, perpendiculairement à la longueur de la partie principale 33.

Le shunt 32 est fabriqué avec au moins un matériau, comprenant ici de la Manganine (CuMn12Ni).

La première pièce 30 comprend de plus des plaques 35a, 35b, fabriquées ici en cuivre, qui sont fixées aux extrémités du shunt 32 de part et d'autre de celui-ci. Les plaques 35a, 35b sont par exemple soudées aux extrémités du shunt 32. Les faces latérales 36 du shunt 32 et les faces latérales 37 des plaques 35a, 35b sont coplanaires. Les faces inférieure 38 et supérieure 39 du shunt 32, et les faces inférieure 40 et supérieure 41 des plaques 35a, 35b sont coplanaires.

Ici, par « supérieur », on entend du côté des bornes 34a, 34b du shunt 32 et par « inférieur », on entend de l'autre côté.

La première pièce 30 forme ainsi un premier élément, qui est électriquement conducteur.

La deuxième pièce 31 à pour forme générale une plaque rectangulaire.

La deuxième pièce 31 est fabriquée avec au moins un matériau, comprenant ici un alliage de Cuivre, par exemple le Cu-ETP C11000.

La deuxième pièce 31 comprend un côté 43, sa longueur supérieure en l'occurrence, dans lequel est formée une échancrure 44 qui définit une portion évidée 45 s'étendant selon une partie de la longueur de la deuxième pièce 31, et une portion non évidée 46 s'étendant selon ladite partie de la longueur de la deuxième pièce 31.

La portion non évidée 46 forme un deuxième élément, qui est électriquement conducteur. Le deuxième élément 46 est donc une partie de la deuxième pièce 31.

Le premier élément 30 s'étend dans l'échancrure 44 de manière à laisser un espace 47 non électriquement conducteur entre le premier élément 30 et le deuxième élément 46. Cet espace 47 est ici vide mais il pourrait être rempli d'un matériau non conducteur.

Ici, chaque extrémité du premier élément 30 comprend un premier renfoncement 48 formé dans son épaisseur, et chaque extrémité du deuxième élément 46 comprend un deuxième renfoncement 49 formé dans son épaisseur.

Le premier élément 30 et le deuxième élément 46 ont leurs extrémités emboitées de sorte que le fond du premier renfoncement 48 de chaque extrémité du premier élément 30 est appliqué contre le fond du deuxième renfoncement 49 d'une extrémité distincte du deuxième élément 46.

Chaque extrémité du premier élément 30 est fixée par une liaison électriquement conductrice à une extrémité distincte du deuxième élément 46. Ici, chaque liaison électriquement conductrice est réalisée par une opération de soudure électrique par point. La soudure par point de deux corps métalliques consiste à maintenir une forte pression entre les deux corps métalliques à souder. On applique alors, pendant une durée très courte, un courant électrique très élevé grâce à des électrodes. Ce courant électrique chauffe les surfaces en contact qui demeurent fixées en refroidissant.

On voit la position des points de soudure 55a, 55b sur la figure 4.

On note de plus que la face supérieure 50 du premier élément 30 et la face supérieure 51 de la deuxième pièce 31 sont coplanaires, et que les faces latérales 52 du premier élément 30 et les faces latérales 53 de la deuxième pièce 31 sont coplanaires.

Ainsi, lorsque le courant principal I traverse le dispositif de mesure de courant 20, il se divise en un premier courant I1 circulant dans le premier élément 30 et en un deuxième courant I2 circulant dans le deuxième élément 46. Le dispositif de mesure de courant 20 comprend donc un diviseur de courant comprenant une première branche formée par le premier élément 30 et une deuxième branche formée par le deuxième élément 46. Le courant principal I se répartit entre les deux branches en fonction de leur impédance respective.

On détourne donc du barreau de cuivre principal, formé par la deuxième pièce 31 et en particulier par sa portion non évidée 46, une partie du courant à mesurer dans un barreau secondaire dans lequel se trouve le shunt de mesure 32. Le barreau secondaire est soudé par-dessus le barreau de cuivre principal.

Le premier courant I1 est donc représentatif du courant principal I (il s'agit d'une « image » de celui-ci).

Avec le shunt 32, l'impédance du premier élément 30 est beaucoup plus forte que l'impédance du deuxième élément 46. Le premier courant I1 traversant le premier élément 30 est ainsi beaucoup plus faible que celui traversant le deuxième élément 46. La puissance dissipée dans le shunt 32 est donc beaucoup plus faible que dans le cas d'un shunt traversé par le courant principal total. Avantageusement, la résistance électrique du premier élément 30 est comprise entre 5 fois et 100 fois la résistance électrique du deuxième élément 46.

Le shunt 32 a par exemple une longueur l₂ de 10mm, une hauteur h₂ de 4mm et une épaisseur e₂ de 1,79mm, et donc une section selon un plan perpendiculaire à sa longueur l₂ de 7,17mm². L'impédance du shunt 32 à 20°C est alors de 599,9µΩ.

Les deux plaques 35a, 35b ont chacune une longueur de 10mm, une hauteur de 4mm, une épaisseur de 1,79mm. L'impédance totale des deux plaques à 20°C est de 48,2µΩ.

La section du premier élément 30 selon un plan perpendiculaire à sa longueur est de 7,2mm².

L'impédance totale du premier élément 30 à 20°C est de 648,0µΩ.

Le deuxième élément 46, quant à lui, a une longueur l₃ de 30mm, une hauteur h₃ de 10mm et une épaisseur de 1,79mm. La section du deuxième élément 46 selon un plan perpendiculaire à sa longueur est de 17,9mm².

L'impédance du deuxième élément 46 à 20°C est de 28,9µΩ.

On constate donc que le deuxième élément a une résistance nettement plus faible, ce qui résulte de la différence de résistance des matériaux utilisés (la résistance de la Manganine est nettement plus élevée que celle du Cuivre).

Ainsi, lorsqu'un courant principal I de 200A traverse le dispositif de mesure de courant 20, le premier courant I1 qui traverse le premier élément 30 est un courant de 8,5A et le deuxième courant I2 qui traverse le deuxième élément 46 est un courant de 191,5A.

Le courant principal I peut donc être évalué à partir de la mesure du premier courant I1 et donc à partir de la mesure de la tension aux bornes du shunt 32.

L'unité de traitement 22 mesure la tension aux bornes du shunt 32, puis évalue le courant principal I à partir de ladite tension. L'unité de traitement 22 peut éventuellement évaluer d'abord le premier courant I1 à partir de la tension, puis le courant principal I à partir du premier courant I1.

Idéalement, il faudrait que la répartition des courants entre les deux branches reste toujours la même quelle que soit la température, afin que la mesure reste inchangée et que le courant principal I puisse être obtenu en multipliant le premier courant I1 (ou la tension aux bornes du shunt 32) par un coefficient constant.

Cependant, comme on l'a vu, le shunt 32 comprend de la Manganine et la plaque 31 comprend un alliage de Cuivre. Ces deux matériaux ne présentent pas la même résistance thermique. Le Cuivre a sa résistance qui dérive en température d'environ 3,93 x 10⁻³/°C, alors que la résistance de la Manganine dérive de 0,001 x 10⁻³/°C.

En fonction de la température, la résistance du deuxième élément 46 va donc varier plus vite que celle du premier élément 30. Le courant dans le shunt 32 varie donc en fonction de la température, ce qui engendre une erreur de mesure.

Le tableau 1 en Annexe comprend les valeurs de tension aux bornes du shunt 32 (en V) en fonction de la température (entre -40°C et +70°C) et l'erreur de mesure relative au point mesuré à 20°C, qui est la température de référence lors de la calibration du compteur 10.

On constate que l'erreur de mesure peut être relativement importante.

Cependant, il est possible de compenser cette erreur de mesure en utilisant des mesures de température produites par le capteur de température 21 précédemment évoqué.

L'unité de traitement 22 compense, en fonction desdites mesures de température, une différence de dérive en température de la résistance électrique du premier élément 30 et de la résistance électrique du deuxième élément 46.

L'unité de traitement 22 :
- mesure une tension aux bornes du shunt 32 ;
- acquiert des mesures de température ;
- détermine, en fonction de la température, une valeur d'un paramètre de compensation permettant de compenser la différence de dérive en température de la résistance électrique du premier élément 30 et de la résistance électrique du deuxième élément 46 ;
- corrige la tension aux bornes du shunt 32 en utilisant ladite valeur dudit paramètre de compensation ;
- évalue le courant principal I à partir de la tension corrigée.

Dans un mode de réalisation, le paramètre de compensation est égal à une valeur de tension constante par unité de température. Cette valeur constante est par exemple de 17,9mV/°C.

L'unité de traitement 22 ajoute à la mesure de tension aux bornes du shunt la valeur du paramètre de compensation correspondant à la température mesurée.

On obtient donc le tableau 2 en Annexe.

On voit que l'erreur de mesure est nettement diminuée et ramenée à des valeurs inférieures aux gabarits imposés par les normes.

Il serait bien sûr possible de compenser la différence de dérive en température de manière différente, ou avec des opérations additionnelles. Il serait possible par exemple d'ajouter en plus un offset positif constant à la tension corrigée du tableau 2 pour réduire encore l'erreur de mesure.

L'invention permet donc d'utiliser un shunt standard, utilisé normalement pour des courants inférieurs à 100A, pour réaliser la mesure de courants forts (par exemple 200A ou 320A).

Au niveau de l'échauffement, la puissance dissipée sous un courant de 200A dans le dispositif de mesure de courant 20 est de 1,11W, contre 7,2W dans un shunt « classique ». La puissance dissipée est donc nettement réduite, et elle est même inférieure à la puissance de 1,46W dissipée dans un Shunt classique sous 90A.

Le coût du dispositif de mesure de courant est peu élevé car il utilise un shunt au design connu (et peu onéreux) et des éléments additionnels très peu onéreux eux aussi. Le dispositif de mesure de courant peut donc être intégré dans un compteur préexistant, conçu initialement pour mesurer des courants faibles, sans modification significative de celui-ci, pour obtenir un compteur capable de mesurer des courants forts (supérieur à 100A typiquement). Le capteur de courant, en particulier, est déjà présent dans le compteur préexistant pour compenser la dérive en température du shunt.

Bien entendu, l'invention n'est pas limitée au mode de réalisation décrit mais englobe toute variante entrant dans le champ de l'invention tel que défini par les revendications.

Le premier élément pourrait comprendre uniquement le shunt, sans les plaques de cuivre décrites ici et positionnées de part et d'autre du shunt. Le shunt pourrait avoir une forme différente.

De même, la deuxième pièce et le deuxième élément pourraient aussi avoir une forme différente.

On a décrit que le premier élément est une pièce « individuelle », alors que le deuxième élément est une partie d'une pièce (de la deuxième pièce 31) : en effet, le courant principal circule bien dans la deuxième pièce de part et d'autre du deuxième élément. Cette configuration n'est pas obligatoire, le deuxième élément pourrait aussi être une pièce individuelle soudée au premier élément. Le deuxième élément pourrait par exemple comprendre deux bras fixés chacun à l'une des extrémités du premier élément.

Tous les matériaux cités ici pourraient être différents.

Le compteur électrique pourrait être un compteur polyphasé.

L'équipement dans lequel est intégré le dispositif de mesure de courant n'est pas nécessairement un compteur électrique, il pourrait s'agir de tout équipement à l'intérieur duquel une mesure de courant est réalisée.

### Annexes

**Tableau 1**

| **Temp. [°C]** | **Tension Shunt [V]** | **Erreur [%]** |
|---|---|---|
| -40 | 4,017 | -21,47% |
| -30 | 4,205 | -17,81% |
| -20 | 4,390 | -14,19% |
| 0 | 4,756 | -7,03% |
| 10 | 4,937 | -3,50% |
| 20 | 5,116 | 0,00% |
| 30 | 5,293 | 3,47% |
| 40 | 5,469 | 6,90% |
| 50 | 5,643 | 10,31% |
| 60 | 5,816 | 13,69% |
| 70 | 5,987 | 17,04% |

**Tableau 2**

| **Temp. [°C]** | **Tension Shunt [V]** | **Erreur [%]** | **Tension corrigée [V]** | **Erreur corrigée [%]** |
|---|---|---|---|---|
| -40 | 4,017 | -21,47% | 5,091 | -0,48% |
| -30 | 4,205 | -17,81% | 5,100 | -0,32% |
| -20 | 4,390 | -14,19% | 5,106 | -0,19% |
| 0 | 4,756 | -7,03% | 5,114 | -0,03% |
| 10 | 4,937 | -3,50% | 5,116 | 0,00% |
| 20 | 5,116 | 0,00% | 5,116 | 0,00% |
| 30 | 5,293 | 3,47% | 5,114 | -0,03% |
| 40 | 5,469 | 6,90% | 5,111 | -0,09% |
| 50 | 5,643 | 10,31% | 5,106 | -0,19% |
| 60 | 5,816 | 13,69% | 5,100 | -0,31 % |
| 70 | 5,987 | 17,04% | 5,092 | -0,46% |

## Revendications

1. Dispositif de mesure de courant (20), agencé pour mesurer un courant principal (I) le traversant, et comprenant :
- un premier élément (30) qui est électriquement conducteur et qui intègre un shunt de mesure (32) ;
- un deuxième élément (46) qui est électriquement conducteur, le deuxième élément étant une partie d'une pièce (31) ayant pour forme générale une plaque rectangulaire ; chaque extrémité du premier élément étant fixée par une liaison électriquement conductrice à une extrémité distincte du deuxième élément, de sorte que le courant principal se divise en un premier courant (I1) circulant dans le premier élément et en un deuxième courant (I2) circulant dans le deuxième élément, le shunt de mesure permettant ainsi de mesurer le premier courant qui est représentatif du courant principal.

2. Dispositif de mesure de courant selon la revendication 1, dans lequel ladite pièce (31) comprend un côté (43) dans lequel est formée une échancrure (44) qui définit une portion évidée (45) s'étendant selon une partie d'une longueur de la pièce, et une portion non évidée (46) s'étendant selon ladite partie de la longueur de la pièce, le deuxième élément étant ladite portion non évidée (46), et le premier élément s'étendant dans l'échancrure (44) de manière à laisser un espace (47) non électriquement conducteur entre le premier élément et le deuxième élément.

3. Dispositif de mesure de courant selon l'une des revendications précédentes, dans lequel chaque extrémité du premier élément comprend un premier renfoncement (48) formé dans son épaisseur et chaque extrémité du deuxième élément comprend un deuxième renfoncement (49) formé dans son épaisseur, le premier élément (30) et le deuxième élément (46) ayant leurs extrémités emboitées de sorte qu'un fond du premier renfoncement (48) de chaque extrémité du premier élément (30) est appliqué contre un fond du deuxième renfoncement (49) d'une extrémité distincte du deuxième élément (46).

4. Dispositif de mesure de courant selon l'une des revendications précédentes, dans lequel le deuxième élément (46) est fabriqué avec au moins un matériau comprenant un alliage de cuivre.

5. Dispositif de mesure de courant selon l'une des revendications précédentes, dans lequel le premier élément (30) comprend le shunt de mesure (32) et deux plaques (35a, 35b) fixées au shunt de mesure (32) et positionnées de part et d'autre du shunt de mesure.

6. Dispositif de mesure de courant selon l'une des revendications précédentes, dans lequel le shunt de mesure (32) est fabriqué avec au moins un matériau comprenant de la Manganine.

7. Dispositif de mesure de courant selon l'une des revendications précédentes, dans lequel chaque liaison électriquement conductrice est réalisée par une opération de soudure par point.

8. Dispositif de mesure de courant selon l'une des revendications précédentes, dans lequel une résistance électrique du premier élément (30) est comprise entre 5 fois et 100 fois une résistance électrique du deuxième élément (46).

9. Equipement électrique (10) intégrant un dispositif de mesure de courant selon l'une des revendications précédentes, l'équipement électrique comprenant une unité de traitement (22) agencée pour :
- mesurer une tension aux bornes du shunt de mesure ;
- évaluer le courant principal (I) à partir de ladite tension.

10. Equipement électrique (10) selon la revendication 9, comprenant en outre un capteur de température (21), l'unité de traitement (22) étant de plus agencée pour acquérir des mesures de température produites par le capteur de température (21) et pour compenser, en fonction desdites mesures de température, une différence de dérive en température d'une résistance électrique du premier élément (30) et d'une résistance électrique du deuxième élément (46).

11. Equipement électrique selon l'une des revendications 9 ou 10, l'équipement électrique étant un compteur électrique (10).

12. Equipement électrique selon l'une des revendications 9 à 11, l'équipement électrique étant agencé pour mesurer, en utilisant le dispositif de mesure de courant, un courant principal supérieur à 100A.

13. Procédé de mesure de courant, mis en œuvre dans l'unité de traitement (22) de l'équipement électrique selon l'une des revendications 10 à 12, et comprenant les étapes de :
- mesurer une tension aux bornes du shunt de mesure (32) ;
- acquérir des mesures de température produites par le capteur de température (21) ;
- déterminer, en fonction de la température, une valeur d'un paramètre de compensation permettant de compenser la différence de dérive en température de la résistance électrique du premier élément (30) et de la résistance électrique du deuxième élément (46) ;
- corriger la tension aux bornes du shunt de mesure (32) en utilisant ladite valeur dudit paramètre de compensation ;
- évaluer le courant principal à partir de la tension corrigée.

14. Programme d'ordinateur comprenant des instructions qui conduisent l'unité de traitement (22) de l'équipement électrique selon l'une des revendications 10 à 12 à exécuter les étapes du procédé de mesure de courant selon la revendication 13.

15. Support d'enregistrement lisible par ordinateur, sur lequel est enregistré le programme d'ordinateur selon la revendication 14.
